# FASCICULE DE BREVET EUROPEEN

(11) **EP 2 748 698 B1**
(45) Date de publication et mention de la délivrance du brevet: **04.11.2015**
(21) Numéro de dépôt: 12819087.3
(22) Date de dépôt: 18.12.2012
(51) Int. Cl.: G06F 3/044

(54) **DISPOSITIF DE MESURE CAPACITIVE A ELECTRODES COMMUTEES POUR INTERFACES TACTILES ET SANS CONTACT**
KAPAZITIVE MESSVORRICHTUNG MIT SCHALTELEKTRODE FÜR BERÜHRUNGSEMPFINDLICHE UND KONTAKTLOSEN SCHNITTSTELLEN
SWITCHED-ELECTRODE CAPACITIVE-MEASUREMENT DEVICE FOR TOUCH-SENSITIVE AND CONTACTLESS INTERFACES

(30) Priorité: 22.12.2011 FR 1162246
(43) Date de publication de la demande: 02.07.2014
(73) Titulaire: Nanotec Solution, 30900 Nîmes (FR)
(72) Inventeur: ROZIERE, Didier, F-30900 Nîmes (FR)
(74) Mandataire: Pontet Allano & Associes
(86) Numéro de dépôt international: PCT/FR2012/052974
(87) Numéro de publication internationale: WO 2013/093327

(56) Documents cités:
- WO-A1-2008/000964
- FR-A1- 2 949 008

## Description

### Domaine technique

La présente invention concerne un dispositif de mesure capacitive pour réaliser des interfaces homme-machines tactiles et sans contact, qui permet une intégration optimale d'un nombre élevé d'électrodes de mesure sur une surface de détection.

Le domaine de l'invention est plus particulièrement mais de manière non limitative celui de des interfaces homme-machine tactiles et sans contact.

### Etat de la technique antérieure

De nombreux appareils de communication et de travail utilisent une interface de commande tactile ou sans contact, tel qu'un pad ou un écran. On trouve par exemple ce genre d'interfaces dans des téléphones mobiles, des smartphones, des ordinateurs à écran tactile, des pads, des PC, des souris, des dalles tactiles et des écrans géants.....

Ces interfaces utilisent fréquemment les technologies capacitives. La surface sensible est équipée d'électrodes conductrices reliées à des moyens électroniques qui permettent de mesurer la variation des capacités apparaissant entre des électrodes et l'objet à détecter pour effectuer une commande.

Il est possible de réaliser des électrodes transparentes, qui permettent de superposer une interface sur un écran d'affichage, par exemple de smartphone.

La plupart de ces interfaces sont tactiles, c'est-à-dire qu'elles peuvent détecter le contact d'un ou de plusieurs objet(s) de commande (usuellement des doigts) avec la surface de l'interface.

Il se développe de plus en plus d'interfaces gestuelles ou sans contact, qui sont en mesure de détecter des objets de commande à une plus grande distance de l'interface, sans contact avec la surface.

Les techniques capacitives actuellement mises en oeuvre dans des interfaces tactiles utilisent le plus souvent deux couches d'électrodes conductrices en forme de lignes et de colonnes. L'électronique mesure les capacités de couplage qui existent entre ces lignes et colonnes. Lorsqu'un doigt est très proche de la surface active, les capacités de couplage à proximité du doigt sont modifiées et l'électronique peut ainsi localiser la position en 2D (XY), dans le plan de la surface active.

Ces technologies, souvent appelées « mutual capacitance » en Anglais, permettent de détecter la présence et la position du doigt au travers d'un diélectrique de faible épaisseur. Elles ont l'avantage de permettre une très bonne résolution dans la localisation dans le plan (XY) de la surface sensible d'un ou de plusieurs doigts. Elles permettent aussi avec un logiciel de traitement approprié de gérer un grand nombre de doigts si la surface de l'interface est suffisamment grande.

Ces techniques ont toutefois l'inconvénient de générer par principe des capacités de fuite importantes au niveau des électrodes de mesure et de l'électronique. En effet la détection d'un doigt est réalisée en mesurant la variation de la capacité de couplage créée entre chaque ligne et colonne dont l'une est émettrice d'un signal électrique et l'autre réceptrice du signal à détecter. Ce signal est proportionnel à la capacité inter ligne et colonne sélectionnées. Lorsque qu'un doigt est très proche de l'intersection du couple ligne et colonne concerné, la capacité de couplage est réduite et la détection du doigt est réalisée.

Ces capacités de couplage, importantes même sans présence de l'objet à détecter, peuvent de plus dériver dans le temps du fait du vieillissement, de la déformation des matériaux, ou de l'effet de la variation de la température environnante. Ces variations peuvent dégrader la sensibilité des électrodes, voire déclencher intempestivement des commandes. C'est une des raisons pour laquelle ces technologies ne peuvent détecter que le contact du doigt et non son approche car il est nécessaire de créer une grande variation de capacité afin de permettre au circuit électrique d'en détecter la variation qui doit être bien supérieure aux dérives pour éviter tout artefact.

On connait également des techniques permettant de mesurer la capacité absolue qui apparaît entre des électrodes et un objet à détecter. Ces techniques sont souvent appelées « self capacitance » en Anglais. On connaît par exemple le document FR 2 756 048 de Rozière qui divulgue un procédé de mesure capacitive qui permet de mesurer la capacité et la distance entre une pluralité d'électrodes indépendantes et un objet à proximité.

Cette technologie utilise une garde afin d'éliminer toute capacité parasite. Toutes les électrodes sont au même potentiel et il n'y ainsi aucune capacité de couplage entre les électrodes susceptible de dégrader la mesure de la capacité.

Cette technologie est bien adaptée pour des interfaces tactiles et sans contact telles que des pads capacitifs et des dalles transparentes tactiles et/ou 3D de petite taille, comme des pads d'ordinateurs portables ou des petits écrans pour smartphone. Par contre, lorsque le pad ou l'écran est de plus grande taille, le nombre d'électrodes nécessaires pour recouvrir toute la surface sensible est trop important pour être géré par un circuit électronique miniature. Et surtout, la surface nécessaire en périphérie de la surface sensible et entre les électrodes pour le passage des pistes reliant les électrodes à l'électronique devient également très importante.

On connaît également le document FR 2 949 008 qui décrit un dispositif de mesure capacitif avec une pluralité d'électrodes de mesure indépendantes et une garde, et des moyens électroniques pour réaliser une autre fonction également référencés au potentiel de la garde.

Il est possible d'utiliser des électrodes en forme de lignes et de colonnes avec cette technique afin de minimiser les problèmes d'interconnexion. Cette structure lignes-colonnes, dans laquelle lignes et colonnes sont utilisées comme électrodes indépendantes, permet une mesure sans contact ou gestuelle à grande distance (détection d'un doigt à plusieurs centimètres) mais un autre problème apparaît lorsque l'on souhaite détecter plus d'un objet. En effet, elle nécessite le scanning de chaque ligne et chaque colonne ce qui donne la mesure d'objets virtuels appelés fantômes. Ces fantômes empêchent la localisation absolue de plusieurs objets sur la surface sensible.

On connaît le document WO 2008/000964 qui décrit un capteur tactile de type piézoélectrique avec une matrice d'électrodes et des éléments de commutation pour relier séquentiellement ces électrodes à des pistes de contrôle et de mesure en lignes et en colonnes.

Le but de la présente invention est de proposer un dispositif de mesure capacitive pour interfaces tactiles et/ou sans contact qui permette la mise en oeuvre d'un nombre élevé d'électrodes de mesure capacitive sur une surface de détection tout en limitant les problèmes d'interconnexion de ces électrodes avec l'électronique de mesure.

### Exposé de l'invention

Cet objectif est atteint avec un dispositif de mesure capacitive pour interfaces tactiles et/ou sans contact, comprenant au moins une électrode de mesure capacitive et des moyens de commutation d'électrode aptes à relier électriquement ladite au moins une électrode, soit à des moyens de mesure capacitive, soit à un potentiel de garde,
caractérisé en ce que ladite au moins une électrode de mesure capacitive et lesdits moyens de commutation d'électrode sont réalisés sur une même surface de détection selon une technique de fabrication de composant électronique de type planaire.

Les techniques de fabrication de composant électronique de type planaire peuvent comprendre notamment des techniques issues de la microélectronique. Elles peuvent comprendre, de manière non limitative, des opérations de dépôt de couches, notamment de couches minces, évaporation, masquage, gravure chimique, gravure sèche, implantation d'ions, dépôt de produits en solution, impression à jet d'encre....

Le dispositif selon l'invention peut comprendre en outre :
- une pluralité d'électrodes de mesure capacitive réparties sur une surface de détection suivant une structure bidimensionnelle avec deux directions croisées,
- des moyens de commutation d'électrode placés à proximité desdites électrodes de mesure sur la surface de détection,
- des premières pistes de liaison électrique disposées sur la surface de détection de telle sorte à être aptes à relier aux moyens de mesure capacitive, par l'intermédiaire de leurs moyens de commutation d'électrode respectifs, une pluralité d'électrodes de mesure réparties sensiblement suivant une première direction, et
- des secondes pistes de liaison électrique disposées sur la surface de détection de telle sorte à être aptes à relier à un signal de commutation les moyens de commutation d'électrode respectifs d'une pluralité d'électrodes de mesure réparties sensiblement suivant la seconde direction.

Les électrodes de mesure capacitive peuvent être notamment réparties sur la surface de détection suivant une structure matricielle sensiblement en lignes et en colonnes.

Suivant des modes de réalisation, le dispositif selon l'invention peut comprendre en outre :
- un plan de garde en matériau sensiblement conducteur à l'électricité, au potentiel électrique de garde, disposé sous les électrodes de mesure et séparé desdites électrodes par au moins une couche de matériau sensiblement isolant à l'électricité ;
- des moyens de commutation d'électrode électriquement reliés au plan de garde par des liaisons électriques traversant la ou les couche(s) de matériau sensiblement isolant.

Les moyens de commutation d'électrode peuvent comprendre deux transistors, dont un premier transistor apte à relier une électrode de mesure aux moyens de mesure capacitive et un second transistor apte à relier ladite électrode de mesure au potentiel de garde, lesquels transistors étant contrôlés par un signal de commutation de telle sorte que lorsque l'un est passant, l'autre est bloqué.

Suivant des modes de réalisation, le dispositif selon l'invention peut comprendre en outre :
- des transistors réalisés selon une technologie de dépôt de couches minces ;
- des transistors sensiblement transparents ;
- des transistors de l'un des types suivants : transistor à effet de champ de type TFT (Transistor à couches minces, « Thin-Film Transistor » en Anglais), transistors à base de semiconducteurs organiques de type OFET (transistor à effet de champ organique).

Suivant des modes de réalisation, le dispositif selon l'invention peut être réalisé de telle sorte à être sensiblement transparent.

Il peut comprendre au moins un élément parmi des électrodes de mesure, un plan de garde et des pistes comprenant de l'ITO (oxyde d'indium dopé à l'étain).

Suivant des modes de réalisation, le dispositif selon l'invention peut comprendre en outre des seconds moyens de commutation aptes à relier des moyens de commutation d'électrode, soit à des moyens de mesure capacitive, soit à un potentiel de garde.

Suivant des modes de réalisation, le dispositif selon l'invention peut comprendre en outre des moyens de mesure capacitive au moins en partie référencés à un potentiel électrique de référence flottant par rapport à un potentiel de masse.

Le potentiel électrique de référence peut être sensiblement égal au potentiel de garde.

Suivant un autre aspect, il est proposé un dispositif d'interface homme-machine comprenant une interface de commande et un dispositif de mesure capacitive selon l'invention.

Le dispositif d'interface homme-machine peut comprendre une interface de commande pourvue d'un écran d'affichage, et un dispositif de mesure capacitive sensiblement transparent.

Suivant encore un autre aspect, il est proposé un appareil de l'un des types suivants : smartphone, tablette, écran d'affichage, ordinateur, pad de commande pour machine ou véhicule, comprenant un dispositif d'interface homme-machine selon l'invention.

Ainsi, suivant des aspects particulièrement avantageux, l'invention permet de réaliser des dispositifs de mesure :
- qui permettent la mise en oeuvre d'électrodes de mesure capacitive indépendantes, de telle sorte à pouvoir effectuer des mesures d'objets multiples sans problème de mesure fantôme,
- tout en minimisant la surface utilisée par les pistes de liaison électrique, puisqu'il suffit d'une piste entre des rangées ou des colonnes d'électrodes de mesure.

La solution de l'invention permet ainsi d'optimiser le nombre et/ou la surface des électrodes de mesure. Il est aussi possible de réaliser des pistes plus larges et plus éloignées des électrodes, ce qui permet d'abaisser leur résistivité (qui peut être non-négligeable lorsqu'on utilise des matériaux tels que de l'ITO) et de limiter les effets parasites dus aux coulages entre pistes et électrodes voisines.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la figure 1 illustre une vue de dessus d'un dispositif de mesure capacitive selon l'invention,
- La figure 2 illustre une vue en coupe du dispositif de mesure capacitive de la figure 1, et
- la figure 3 illustre un mode de réalisation d'une électronique de mesure capacitive mise en oeuvre dans le dispositif de mesure capacitive des figures 1 et 2.

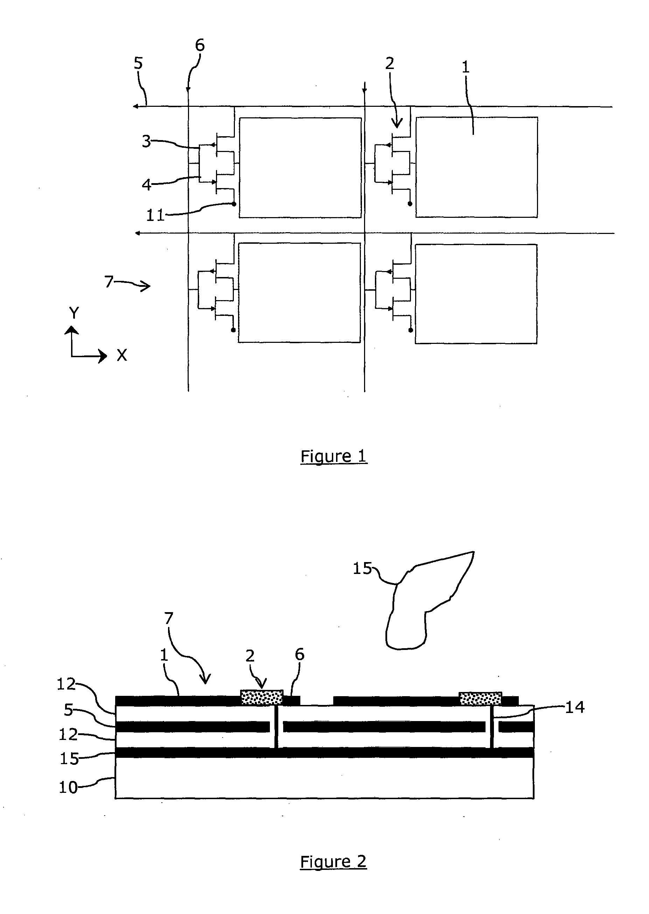

Les figures 1, 2 et 3 sont des schémas illustratifs dont aucune information d'échelle ou de proportions ne peut être déduite.

On va décrire un exemple de mode de réalisation d'un dispositif selon l'invention, permettant de fabriquer des interfaces tactiles et sans contact pour des systèmes ou des appareils tels que des téléphones portables (smartphones), des tablettes, des ordinateurs ou des dalles de commande.

En référence aux figures 1 et 2, le dispositif de mesure selon l'invention comprend une pluralité d'électrodes de mesure capacitive 1 réparties sur une surface de détection 7 selon une structure matricielle en lignes et en colonnes, correspondant à deux directions croisées X, Y.

La surface de détection 7 constitue la surface d'une interface de commande 10 qui comprend un écran d'affichage, par exemple de type TFT (transistor à couches minces) ou OLED (diodes électroluminescentes organiques).

L'interface de commande 10 et le dispositif de mesure capacitive superposé constituent une interface homme-machine pour le système.

Les électrodes 1 permettent de détecter l'approche et/ou le contact d'un ou plusieurs objet(s) d'intérêt 15 tel qu'un doigt 15 par mesure du couplage capacitif qui s'établit entre elles et le doigt 15.

La distance entre le doigt 15 et les électrodes 1 peut être déduite de la mesure du couplage capacitif, tandis que la localisation du doigt 15 dans le plan (X, Y) de la surface de détection 7 peut être obtenue à partir de la localisation des électrodes 1 qui détectent la présence du doigt 15.

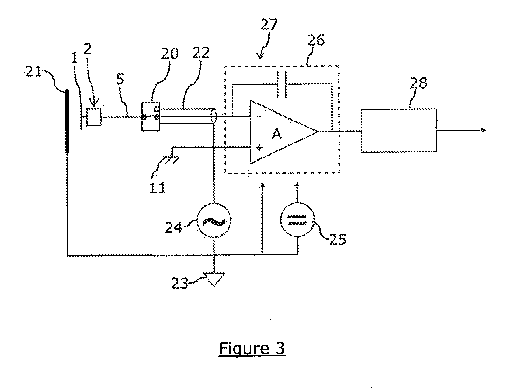

En référence à la figure 3, le couplage capacitif est mesuré par des moyens électroniques de mesure capacitive 27.

Les électrodes 1 sont reliées à des moyens de commutation d'électrode 2 qui permettent de les relier :
- soit aux moyens électroniques de mesure capacitive 27 par l'intermédiaire de premières pistes de liaison électrique 5, ou pistes de mesure 5,
- soit à un potentiel de garde 11.

Les moyens de commutation d'électrode 2 sont contrôlés par un signal de commutation auquel ils sont reliés par des secondes pistes de liaison électrique 6, ou pistes de commutation 6.

Les pistes de mesure 5 relient des électrodes 1 réparties suivant une direction X de la matrice, et les pistes de commutation 6 relient des électrodes 1 réparties suivant une seconde direction Y de la matrice.

Le dispositif comprend également un plan de garde 15 à un potentiel électrique de garde 11, qui est placé sous les électrodes 1 à l'opposé de leur surface de détection. Ce plan de garde 15 constitue un blindage électrique qui protège les électrodes de l'influence de L'interface de commande 10.

L'ensemble est réalise selon une structure multicouche avec :
- une première couche comprenant les électrodes 1, les pistes de mesure 5 et les moyens de commutation d'électrode 2,
- une seconde couche comprenant les pistes de commutation 6, et
- une troisième couche comprenant le plan de garde 15.

Les couches sont séparées par des couches de matériau isolant 12.

Les moyens de commutation sont reliés au potentiel de garde 11 par des liaisons traversantes 14 connectées au plan de garde 15.

Les électrodes 1, le plan de garde 15 et les pistes 5, 6 sont réalisés avec un matériau sensiblement transparent tel que de l'ITO (oxyde d'indium dopé à l'étain) déposé, par exemple par évaporation sous vide, sur la couche diélectrique isolante sous-jacente.

La surface de l'interface de commande 10 peut être en verre ou un polymère comme le PET.

Les couches de matériau isolant 12 sont dans un matériau polymère.

Les moyens de commutation 1 comprennent deux transistors de type à effet de champ 3, 4, dont l'un est à canal N et l'autre à canal P :
- la grille (« gate ») des deux transistors 3, 4 est reliée à une piste de commutation 6 qui véhicule le signal de commutation,
- un premier transistor 3 est relié par ses deux autres bornes (drain et source) respectivement à une piste de mesure 5 et à l'électrode 1,
- un second transistor 4 est relié par ses deux autres bornes (drain et source) respectivement au potentiel de garde 11 et à l'électrode 1.

Suivant la polarité et/ou le niveau du signal de commutation, l'un des transistors 3, 4 est passant avec une résistance électrique très faible tandis que l'autre est bloqué avec une résistance électrique très élevée, et vice et versa. Ainsi, l'électrode 1 est toujours reliée, soit à une piste de mesure 5, soit au potentiel de garde 11.

Les transistors 3, 4 sont réalisés en mettant en oeuvre une technique permettant de réaliser des transistors sensiblement transparents pour l'oeil humain. Ainsi, l'ensemble du dispositif de mesure capacitif est suffisamment transparent pour pouvoir être superposé à un écran d'affichage.

Deux familles de techniques connues conviennent pour la réalisation des transistors 3, 4 dans le mode de réalisation présenté : les transistors de type TFT (transistors à couches minces) ou OFET (transistors à effet de champ réalisés à partir de semi-conducteurs organiques). Dans les deux cas, les électrodes peuvent être réalisées en ITO.

Les transistors de type TFT sont basés sur des dépôts en couche mince de silicium. Il s'agit d'une technique très commune pour la réalisation des écrans d'affichage, mais qui a l'inconvénient, au moins pour certains modes de réalisation, de nécessiter des opérations à température élevée.

Les transistors de type OFET sont réalisés à partir de semi-conducteurs organiques, en utilisant des structures souvent similaires à celles des transistors TFT. Ils peuvent mettre en oeuvre par exemple comme diélectrique de grille (« gate ») un polymère organique tel que du polymethylmethacrylate (PMMA).

Les transistors de type OFETs peuvent être réalisés à partir de techniques bien connues d'évaporation sous vide, par dépôt de solutions de polymères, par transfert mécanique ou même par des techniques d'impression par jet d'encre. Ils ont donc l'avantage de pouvoir être réalisés par des techniques de faible coût à température ambiante.

Les électrodes de mesure 1 sont reliées à des moyens électroniques de mesure capacitive 27 par l'intermédiaire des pistes de mesure 5.

Ces moyens électroniques de mesure capacitive 27, dans le mode de réalisation de la figure 3, sont réalisés sous la forme d'un système de mesure capacitive en pont flottant tel que décrit par exemple dans le document FR 2 756 048 de Rozière.

Le circuit de détection comprend une partie dite flottante 26 dont le potentiel de référence 11, appelé potentiel de garde 11, oscille par rapport à la masse 23 du système global, ou à la terre. La différence de potentiel alternative entre le potentiel de garde 11 et la masse 23 est générée par une source d'excitation, ou un oscillateur 24.

La partie flottante 26 comprend la partie sensible de la détection capacitive, représentée sur la figure 3 par un amplificateur de charge. Elle peut bien entendu comprendre d'autres moyens de traitement et de conditionnement du signal, y compris numériques ou à base de microprocesseur, également référencés au potentiel de garde 11. Ces moyens de traitement et de conditionnement permettent par exemple de calculer des informations de distance et de pression à partir des mesures capacitives.

L'alimentation électrique de la partie flottante 26 est assurée par des moyens flottants de transfert d'alimentation 25, comprenant par exemple des convertisseurs DC/DC.

Ce système de mesure capacitive permet de mesurer une information de capacité entre une électrode de mesure 1 et un objet tel qu'un doigt 15.

L'objet à détecter 15 doit être relié à un potentiel différent du potentiel de garde 11, tel que par exemple le potentiel de masse 23. On se retrouve bien dans cette configuration pour un doigt 15 d'un utilisateur dont le corps définit une masse électrique.

Un ensemble de commutateurs ou de switchs analogiques 20, pilotés par des moyens de contrôle électroniques, permet de sélectionner une piste de mesure 5. Cela sélectionne potentiellement toutes les électrodes 1 d'une ligne dans le mode de réalisation de la figure 1.

Les switchs 20 sont configurés de telle sorte qu'une piste de mesure 5 est reliée soit à l'électronique de détection capacitive 27, soit au potentiel de garde 11.

La sélection d'une électrode 1 particulière reliée à cette piste de mesure 5 est effectuée en envoyant un signal de commutation sur la piste de commutation 6 correspondante, de telle sorte à configurer les moyens de commutation d'électrode 2 de l'électrode 1 pour la relier à la piste de mesure 5.

Ainsi, il est possible de ne relier qu'une seule électrode 1 à l'électronique de détection capacitive 27 pour en mesurer la capacité de couplage avec l'objet 15.

Toutes les électrodes peuvent ainsi être « interrogées » séquentiellement et individuellement. Il est également possible d'interroger globalement des groupes d'électrodes 1 en activant plusieurs signaux de commutation et/ou en mettant en oeuvre plusieurs électroniques de détection 27.

Les électrodes 1 qui ne sont pas reliées à l'électronique de détection capacitive 27 sont toutes reliées au potentiel de garde 11, soit par les moyens de commutation d'électrode 2, soit par les switchs 20.

La partie sensible de la détection est protégée par un blindage de garde 22 relié au potentiel de garde 11.

Ainsi, une électrode active 1 reliée à l'électronique de détection capacitive 27 est environnée par des éléments reliés au potentiel de garde 11, dont des électrodes inactives 1 et selon sa face arrière le plan de garde 15.

Comme l'électrode de mesure active 1 est également au potentiel de garde 11, on évite ainsi l'apparition de capacités parasites entre cette électrode 1 et son environnement, de telle sorte que seul le couplage avec l'objet d'intérêt 15 soit mesuré avec une sensibilité maximale.

L'électronique flottante 26 est reliée en sortie à l'électronique du système 28 référencée à la masse 23 par des liaisons électriques compatibles avec la différence de potentiels de référence. Ces liaisons peuvent comprendre par exemple des amplificateurs différentiels ou des optocoupleurs.

On obtient ainsi des informations sur la position de l'objet ou des objets 15 dans l'espace relativement à la surface de détection 7.

Ces informations sont traitées par l'électronique de détection 27 et transmises à l'électronique du système 28 pour être exploitées notamment dans l'interface homme-machine.

Suivant des variantes :
- Le dispositif de mesure capacitive peut être réalisé par des structures de couches variées, dont notamment (i) les pistes de commutation 6 sur la même couche que les électrodes 1 et les pistes de mesure 5 sur une seconde couche, ou (ii) les pistes de commutation 6 et de mesure 5 sur une même couche, avec ou sans les électrodes 1, et avec des ponts de liaison électrique aux points de croisement ;
- Le dispositif peut comprendre des pistes de garde permettant de relier les moyens de commutation d'électrodes 2 au potentiel de garde 11 au bord de la surface de détection, éventuellement sans liaison traversante 14 ;
- Les moyens de commutation d'électrode 2, dont en particulier les transistors 3, 4, peuvent être réalisés sur une couche différente des électrodes 1. Ils peuvent être placés sous les électrodes 1 pour optimiser la surface utile pour la détection ;
- Les moyens de commutation d'électrode 2 peuvent être regroupés dans des zones particulières de la surface de détection 7 (bords, zones dans lesquelles il est possible de mettre en oeuvre des transistors qui ne sont pas transparents) ;
- Le dispositif de mesure capacitive peut être réalisé avec des électrodes métalliques et/ou un plan de garde métallique et/ou des transistors non transparents, opaques (FET, MOSFET, ...), notamment pour des applications pour lesquelles il n'est pas prévu d'affichage sous-jacent.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif de mesure capacitive pour interfaces tactiles et/ou sans contact, comprenant au moins une électrode de mesure capacitive (1) et des moyens de commutation d'électrode (2) aptes à relier électriquement ladite au moins une électrode (1), soit à des moyens de mesure capacitive (27), soit à un potentiel de garde (11),
**caractérisé en ce que** ladite au moins une électrode de mesure capacitive (1) et lesdits moyens de commutation d'électrode (2) sont réalisés sur une même surface de détection (7) selon une technique de fabrication de composant électronique de type planaire.

2. Le dispositif de la revendication 1, qui comprend en outre :
- une pluralité d'électrodes de mesure capacitive (1) réparties sur une surface de détection (7) suivant une structure bidimensionnelle avec deux directions croisées (X, Y),
- des moyens de commutation d'électrode (2) placés à proximité desdites électrodes de mesure (1) sur la surface de détection (7),
- des premières pistes de liaison électrique (5) disposées sur la surface de détection (7) de telle sorte à être aptes à relier aux moyens de mesure capacitive (27), par l'intermédiaire de leurs moyens de commutation d'électrode (2) respectifs, une pluralité d'électrodes de mesure (1) réparties sensiblement suivant une première direction (X), et
- des secondes pistes de liaison électrique (6) disposées sur la surface de détection (7) de telle sorte à être aptes à relier à un signal de commutation les moyens de commutation d'électrode (2) respectifs d'une pluralité d'électrodes de mesure (1) réparties sensiblement suivant la seconde direction (Y).

3. Le dispositif de l'une des revendications précédentes, qui comprend en outre un plan de garde (15) en matériau conducteur à l'électricité, au potentiel électrique de garde (11), disposé sous les électrodes de mesure (1) et séparé desdites électrodes (1) par au moins une couche de matériau isolant à l'électricité (12).

4. Le dispositif de la revendication 3, qui comprend en outre des moyens de commutation d'électrode (2) électriquement reliés au plan de garde (15) par des liaisons électriques (14) traversant la ou les couche(s) de matériau isolant (12).

5. Le dispositif de l'une des revendications précédentes, dans lequel les moyens de commutation d'électrode (2) comprennent deux transistors (3, 4), dont un premier transistor (3) apte à relier une électrode de mesure (1) aux moyens de mesure capacitive (27) et un second transistor (4) apte à relier ladite électrode de mesure (1) au potentiel de garde (11), lesquels transistors (3, 4) étant contrôlés par un signal de commutation de telle sorte que lorsque l'un est passant, l'autre est bloqué.

6. Le dispositif de la revendication 5, qui comprend en outre des transistors (3, 4) réalisés selon une technologie de dépôt de couches minces.

7. Le dispositif de l'une des revendications 5 ou 6, qui comprend en outre des transistors (3, 4) sensiblement transparents.

8. Le dispositif de l'une des revendications 5 à 7, qui comprend en outre des transistors (3, 4) de l'un des types suivants :
- transistor à effet de champ de type TFT,
- transistors à base de semi-conducteurs organiques de type OFET.

9. Le dispositif de l'une des revendications précédentes, qui est réalisé de telle sorte à être sensiblement transparent.

10. Le dispositif de l'une des revendications précédentes, qui comprend au moins un élément parmi des électrodes de mesure (1), un plan de garde (15) et des pistes (5, 6) comprenant de l'ITO.

11. Le dispositif de l'une des revendications précédentes, qui comprend en outre des seconds moyens de commutation (20) aptes à relier des moyens de commutation d'électrode (2), soit à des moyens de mesure capacitive (27), soit à un potentiel de garde (11).

12. Le dispositif de l'une des revendications précédentes, qui comprend en outre des moyens de mesure capacitive (27) au moins en partie référencés à un potentiel électrique de référence flottant (11) par rapport à un potentiel de masse (23).

13. Le dispositif de la revendication 12, dans lequel le potentiel électrique de référence est sensiblement égal au potentiel de garde (11).

14. Dispositif d'interface homme-machine comprenant une interface de commande (10) et un dispositif de mesure capacitive selon l'une des revendications précédentes.

15. Le dispositif d'interface homme-machine de la revendication 14, qui comprend une interface de commande (10) pourvue d'un écran d'affichage, et un dispositif de mesure capacitive sensiblement transparent.

16. Appareil de l'un des types suivants : smartphone, tablette, écran d'affichage, ordinateur, pad de commande pour machine ou véhicule, comprenant un dispositif d'interface homme-machine selon l'une des revendications 14 ou 15.

## Patentansprüche

1. Vorrichtung zur kapazitiven Messung für Berührungs- und/oder berührungslose Schnittstellen, umfassend wenigstens eine Elektrode zur kapazitiven Messung (1) und Elektrodenumschaltmittel (2), die geeignet sind, die wenigstens eine Elektrode (1) entweder mit Mitteln zur kapazitiven Messung (27) oder mit einem Schutzpotential (11) elektrisch zu verbinden,
**dadurch gekennzeichnet, dass** die wenigstens eine Elektrode zur kapazitiven Messung (1) und die Elektrodenumschaltmittel (2) auf einer gleichen Erfassungsfläche (7) entsprechend einer Technik zur Herstellung elektronischer Bauelemente vom planaren Typ ausgebildet sind.

2. Vorrichtung nach Anspruch 1, die ferner umfasst:
- eine Vielzahl von Elektroden zur kapazitiven Messung (1), die auf einer Erfassungsfläche (7) entsprechend einer zweidimensionalen Struktur mit zwei gekreuzten Richtungen (X, Y) verteilt sind,
- Elektrodenumschaltmittel (2), die in der Nähe der Messelektroden (1) auf der Erfassungsfläche (7) platziert sind,
- erste Leiterbahnen zur elektrischen Verbindung (5), die auf der Erfassungsfläche (7) derart angeordnet sind, dass sie geeignet sind, eine Vielzahl von Messelektroden (1), die im Wesentlichen entlang einer ersten Richtung (X) verteilt sind, mittels ihrer jeweiligen Elektrodenumschaltmittel (2) mit den Mitteln zur kapazitiven Messung (27) zu verbinden, und
- zweite Leiterbahnen zur elektrischen Verbindung (6), die auf der Erfassungsfläche (7) derart angeordnet sind, dass sie geeignet sind, die jeweiligen Elektrodenumschaltmittel (2) einer Vielzahl von Messelektroden (1), die im Wesentlichen entlang der zweiten Richtung (Y) verteilt sind, mit einem Umschaltsignal zu verbinden.

3. Vorrichtung nach einem der vorhergehenden Ansprüche, die ferner eine Schutzebene (15) aus elektrisch leitendem Material, auf dem elektrischen Schutzpotential (11), die unter den Messeelektroden (1) angeordnet und von den Elektroden (1) durch wenigstens eine Schicht aus elektrisch isolierendem Material (12) getrennt ist, umfasst.

4. Vorrichtung nach Anspruch 3, die ferner Elektrodenumschaltmittel (2) umfasst, die mit der Schutzebene (15) durch elektrische Verbindungen (14), welche die Isoliermaterialschicht oder -schichten (12) durchqueren, elektrisch verbunden sind.

5. Vorrichtung nach einem der vorhergehenden Ansprüche, wobei die Elektrodenumschaltmittel (2) zwei Transistoren (3, 4) umfassen, darunter ein erster Transistor (3), der geeignet ist, eine Messelektrode (1) mit den Mitteln zur kapazitiven Messung (27) zu verbinden, und ein zweiter Transistor (4), der geeignet ist, die Messelektrode (1) mit dem Schutzpotential (11) zu verbinden, wobei die Transistoren (3, 4) durch ein Umschaltsignal derart gesteuert werden, dass wenn der eine durchlassend ist, der andere gesperrt ist.

6. Vorrichtung nach Anspruch 5, die ferner Transistoren (3, 4), die nach einer Dünnschicht-Abscheidungstechnik ausgebildet sind, umfasst.

7. Vorrichtung nach einem der Ansprüche 5 oder 6, die ferner im Wesentlichen transparente Transistoren (3, 4) umfasst.

8. Vorrichtung nach einem der Ansprüche 5 bis 7, die ferner Transistoren (3, 4) von einem der folgenden Typen umfasst:
- Feldeffekttransistor vom Typ TFT,
- Transistoren auf der Basis von organischen Halbleitern vom Typ OFET.

9. Vorrichtung nach einem der vorhergehenden Ansprüche, die derart ausgebildet ist, dass sie im Wesentlichen transparent ist.

10. Vorrichtung nach einem der vorhergehenden Ansprüche, die wenigstens ein Element aus Messelektroden (1), einer Schutzebene (15) und Leiterbahnen (5, 6) mit ITO umfasst.

11. Vorrichtung nach einem der vorhergehenden Ansprüche, die ferner zweite Umschaltmittel (20) umfasst, die geeignet sind, Elektrodenumschaltmittel (2) entweder mit Mitteln zur kapazitiven Messung (27) oder mit einem Schutzpotential (11) zu verbinden.

12. Vorrichtung nach einem der vorhergehenden Ansprüche, die ferner Mittel zur kapazitiven Messung (27), die wenigstens teilweise auf ein gegenüber einem Massepotential (23) schwebendes elektrisches Referenzpotential (11) referenziert sind, umfasst.

13. Vorrichtung nach Anspruch 12, bei der das elektrische Referenzpotential im Wesentlichen gleich dem Schutzpotential (11) ist.

14. Mensch-Maschine-Schnittstellenvorrichtung, umfassend eine Bedienungsschnittstelle (10) und eine Vorrichtung zur kapazitiven Messung nach einem der vorhergehenden Ansprüche.

15. Mensch-Maschine-Schnittstellenvorrichtung nach Anspruch 14, die eine mit einem Display versehene Bedienungsschnittstelle (10) und eine im Wesentlichen transparente Vorrichtung zur kapazitiven Messung umfasst.

16. Gerät von einem der folgenden Typen: Smartphone, Tablet-PC, Display, Computer, Control Pad für Maschine oder Fahrzeug, umfassend eine Mensch-Maschine-Schnittstellenvorrichtung nach einem der Ansprüche 14 oder 15.

## Claims

1. Capacitive measurement device for touch-sensitive and/or contactless interfaces comprising at least one capacitive measurement electrode (1) and means of electrode switching (2) capable of electrically connecting said at least one electrode (1) either to capacitive measurement means (27) or to a guard potential (11),
**characterized in that** said at least one capacitive measurement electrode (1) and said means of electrode switching (2) are produced on a single detection surface (7) according to a manufacturing technique for electronic components of planar type.

2. Device according to claim 1, which comprises moreover:
- a plurality of capacitive measurement electrodes (1) distributed over a detection surface (7) according to a two-dimensional structure with two intersecting directions (X, Y),
- means of electrode switching (2) placed nearby said measurement electrodes (1) on the detection surface (7),
- first electrical connection tracks (5) arranged on the detection surface (7) in such a way as to be capable of connecting to the capacitive measurement means (27) via their respective means of electrode switching (2), a plurality of measurement electrodes (1) distributed approximately in a first direction (X), and
- second electrical connection tracks (6) arranged on the detection surface (7) in such a way as to be capable of connecting at a switching signal the respective means of electrode switching (2) of a plurality of measurement electrodes (1) distributed approximately in the second direction (Y).

3. Device according to one of the preceding claims, which comprises moreover a guard plane (15) in an electrically conductive material, at the electrical guard potential (11), arranged below the measurement electrodes (1) and separated from said electrodes (1) by at least one layer of an electrically insulating material (12).

4. Device according to claim 3, which comprises moreover means of electrode switching (2) connected electrically to the guard plane (15) by electrical connections (14) passing through the layer(s) of insulating material (12).

5. Device according to one of the preceding claims in which the means of electrode switching (2) comprise two transistors (3, 4), of which a first transistor (3) is capable of connecting a measurement electrode (1) to the capacitive measurement means (27) and a second transistor (4) is capable of connecting said measurement electrode (1) to the guard potential (11), which transistors (3, 4) are controlled by a switching signal such that when one is on-state the other is off-state.

6. Device according to claim 5, which comprises moreover transistors (3, 4) produced according to a thin layer deposition technology.

7. Device according to one of claims 5 or 6, which comprises moreover transistors (3, 4) which are substantially transparent.

8. Device according to one of claims 5 to 7, which comprises moreover transistors (3, 4) of one of the following types:
- TFT type field-effect transistor,
- OFET type transistors based on organic semiconductors.

9. Device according to one of the preceding claims which is produced in such a way as to be substantially transparent.

10. Device according to one of the preceding claims which comprises at least one element among measurement electrodes (1), a guard plane (15) and tracks (5, 6) comprising ITO.

11. Device according to one of the preceding claims which comprises moreover second switching means (20) capable of connecting the means of electrode switching (2), either to capacitive measurement means (27), or to a guard potential (11).

12. Device according to one of the preceding claims which comprises moreover capacitive measurement means (27) at least in part referenced to a reference electrical potential (11) which is floating with respect to earth potential (23).

13. Device according to claim 12, in which the reference electrical potential is approximately equal to the guard potential (11).

14. Human-machine interface device comprising a command interface (10) and a capacitive measurement device according to one of the preceding claims.

15. Human-machine interface device according to claim 14 which comprises a command interface (10) equipped with a display screen, and a capacitive measurement device which is substantially transparent.

16. Device of one of the following types: smartphone, tablet, display screen, computer, control pad for a machine or vehicle, comprising a human-machine interface device according to one of claims 14 or 15.
